# EUROPEAN PATENT SPECIFICATION

(11) **EP 4 431 964 B1**
(45) Date of publication and mention of the grant of the patent: **01.07.2026**
(21) Application number: 24158255.0
(22) Date of filing: 16.02.2024
(51) Int. Cl.: G01R 31/74, G01R 31/396

(54) **DETERMINING A STATE OF A FUSE**
BESTIMMUNG EINES ZUSTANDS EINER SICHERUNG
DÉTERMINATION D'UN ÉTAT D'UN FUSIBLE

(30) Priority: 16.03.2023 US 202318184985
(43) Date of publication of application: 18.09.2024
(73) Proprietor: Caterpillar, Inc., Peoria, IL 61629-6450 (US)
(72) Inventor: N, Srihari Ranganathan, 641025 Coimbatore (IN); RAJALA, V Kameswara Kiran Kumar, 533001 Kakinada (IN); EDWARDS, Stephen Adam, Peterborough, PE6 7RG (GB); MCCLOSKEY, James Kieran, Stamford, PE9 3EE (GB); OYEKAN, Joseph Oluwagbeminiyi, Peterborough, PE1 5AZ (GB)
(74) Representative: Novagraaf Group

(56) References cited:
- JP-A- 2012 119 249
- US-A1- 2013 141 828
- US-A1- 2022 334 189

## Description

### Field of the Disclosure

The disclosure relates to the field of battery management. More particularly, the present disclosure relates to a system and a method for determining a state of a fuse within a battery pack.

### Background

It is known for battery packs to comprise a plurality of strings connected in parallel, wherein each string comprises one or more cells. The battery management system (BMS) is known to calculate the current limit of a battery pack based on the number of strings that are online. In some architectures and applications, each string comprises a string contactor. In these cases, the BMS is able to determine how many strings are online, and the current levels may be adjusted. However, in some architectures and applications the strings do not comprise string contactors, so the BMS assumes all strings are online and does not detect if string fuses are intact or in a blown state. In the event of a blown fuse on a string, the current limits are not adjusted for the string being offline and there is a risk of overloading the remaining active strings.

US Patent 10,135,243, referred to herein as the '243 reference, describes a method of determining fuse blowout based on how often cell equalisation or balancing occurs. The '243 reference assumes that the likelihood of cell balancing occurring is higher when there is a blown cell fuse. The method of the '243 reference requires one fuse per cell, and is therefore usable only for cells connected in parallel. The method of the '243 reference requires tracking the frequency of cell balancing over a period of time, where frequency of cell balancing is the number of times discharging for cell balancing occurs in a certain time period, or a cumulative duration of discharging for cell balancing in a certain time period. The method of the '243 reference cannot facilitate a rapid determination of the state of the fuses. Furthermore, the method of the '243 reference is usable in determining the state of the fuses only when the battery is running (in closed circuit) so cannot allow the fuses to be determined before use of the battery.

US 2022/334189 A1 describes an apparatus and method for detecting a defect of a battery pack. A battery cell at which a defect is detected inside a battery pack may be disconnected.

It is an object of the present disclosure to help manufacturers and users of battery packs determine the state of the fuses rapidly, reliably and cost-effectively.

### Summary

According to first aspect of the present disclosure, a method is provided for determining a state of a fuse in a battery pack. The battery pack comprises a first string comprising a first string fuse. The first string further comprises at least one parallel arrangement comprising a battery cell and a resistor, wherein the parallel arrangement is configured to be changeable between a connected state wherein the resistor is connected in parallel to the battery cell; and a disconnected state wherein the resistor is disconnected from the battery cell. The first string further comprises a first ammeter, wherein the first string fuse, the at least one parallel arrangement and the first ammeter are connected in series. The battery pack further comprises a second string connected in parallel to the first string, the second string comprising at least one battery cell. The method comprises determining a state of the first string fuse by changing the at least one parallel arrangement of the first string to the connected state. The method further comprises measuring a first current passing through the first string using the first ammeter during a first time period after the at least one parallel arrangement is changed to the connected state. The method further comprises determining whether a change in the first current during the first time period is greater than a threshold current change. In an event that the change in the first current during the first time period does not exceed the threshold current change, the method further comprises providing a notification that the first string fuse is in a blown state. In an event that the change in the first current during the first time period is greater than the threshold current change, the first string fuse is determined to be intact.

In this way, it is possible to determine whether the first string fuse is in tact or broken by using a resistor to partially discharge a battery cell of the first string and measuring the current flow through the first string. In an event that the first string fuse is in tact, current will flow to compensate for the dissipated charge. In an event that the first string fuse is broken, no current will be able to flow. This allows a state of the fuse to be determined before the battery is connected to a load, since no power is required. Knowledge of a broken fuse or open circuit means that current limits of the battery pack or multi-pack battery can be adjusted to avoid overloading the other strings and/or any other battery packs. This method allows a rapid and reliable determination of the state of the first string fuse. Furthermore, the method may allow a state of a string fuse to be determined for a string having one string fuse and more than one battery cell.

According to a second aspect of the present disclosure, a battery management system is provided wherein the battery management system is configured to carry out the method of the first aspect of the disclosure.

According to a third aspect of the present disclosure, a machine is provided wherein the machine comprises an electrical load and a battery pack coupled to the electrical load.

The battery pack comprises a first string comprising a first string fuse. The first string further comprises at least one parallel arrangement comprising a battery cell and a resistor, wherein the parallel arrangement is configured to be changeable between a connected state wherein the resistor is connected in parallel to the battery cell; and a disconnected state wherein the resistor is disconnected from the battery cell. The first string further comprises a first ammeter, wherein the first string fuse, the at least one parallel arrangement and the first ammeter are connected in series. The battery pack further comprises a second string connected in parallel to the first string, the second string comprising at least one battery cell. The machine further comprises a battery management system configured to carry out the method of the first aspect of the disclosure.

According to a fourth aspect of the disclosure, a method is provided of detecting the presence or absence of an open circuit in a battery pack. The battery pack comprises a first string comprising a first string fuse. The first string further comprises at least one parallel arrangement comprising a battery cell and a resistor, wherein the parallel arrangement is configured to be changeable between a connected state wherein the resistor is connected in parallel to the battery cell; and a disconnected state wherein the resistor is disconnected from the battery cell. The first string further comprises a first ammeter, wherein the first string fuse, the at least one parallel arrangement and the first ammeter are connected in series. The battery pack further comprises a second string connected in parallel to the first string, the second string comprising at least one battery cell. The method comprises changing the at least one parallel arrangement to the connected state. The method further comprises measuring a first current passing through the first string using the first ammeter during a first time period after the at least one parallel arrangement is changed to the connected state. The method further comprises determining whether a change in the first current during the first time period is greater than a threshold current change. In an event that the change in the first current during the first time period does not exceed the threshold current change, the method further comprises providing a notification that the first string comprises a break in the circuit. In an event that the change in the first current during the first time period is greater than the threshold current change, the first string is determined to be intact.

### Brief Description of the Drawings

A specific embodiment of the disclosure will now be described, by way of example only, with reference to the accompanying drawings in which:
FIG. 1 shows a circuit diagram of a battery pack suitable for carrying out a method according to an embodiment of the present disclosure.
FIG. 2 shows a flow chart illustrating a method for determining a state of a fuse according to an embodiment of the present disclosure.
FIG. 3 shows circuit diagrams of the battery pack of FIG. 1, wherein the first string fuse is in tact. FIG. 3A shows a circuit diagram for when the parallel arrangement of the first string in a disconnected state. FIG. 3B shows a circuit diagram for when the parallel arrangement of the first string in a connected state. FIG. 3C illustrates the current flow while the parallel arrangement of the first string in a connected state.
FIG. 4 shows circuit diagrams of a battery pack of FIG. 1, wherein the first string fuse is broken. FIG. 4A shows a circuit diagram for when the parallel arrangement of the first string in a disconnected state. FIG. 4B shows a circuit diagram for when the parallel arrangement of the first string in a connected state. FIG. 4C illustrates the lack of current flow while the parallel arrangement of the first string in a connected state.
FIG. 5 shows a circuit diagram of a battery pack suitable for carrying out a method according to an embodiment of the present disclosure, wherein the first string comprises more than one parallel arrangement.
FIG. 6 shows a circuit diagram of a battery pack suitable for carrying out a method according to an embodiment of the present disclosure, wherein the second string comprises a parallel arrangement.
FIG. 7 shows a circuit diagram of a battery pack suitable for carrying out a method according to an embodiment of the present disclosure, wherein battery pack is connected to a load.
FIG. 8A shows a schematic circuit diagram of six strings of a battery pack according to an embodiment of the present disclosure. FIG. 8B shows the current flow through six strings of a battery pack such as that shown in FIG. 8A during a method of determining the state of the first string fuse according to an embodiment of the present disclosure.
FIG. 9 shows a schematic circuit diagram of a battery pack connected to a battery management system according to an embodiment of the present disclosure.
FIG. 10 shows a schematic circuit diagram of a battery pack connected to a battery management system and a machine according to an embodiment of the present disclosure.
FIG. 11 shows a flowchart illustrating a method of detecting the presence or absence of an open circuit in a battery pack, according to an embodiment of the present disclosure.

### Detailed Description

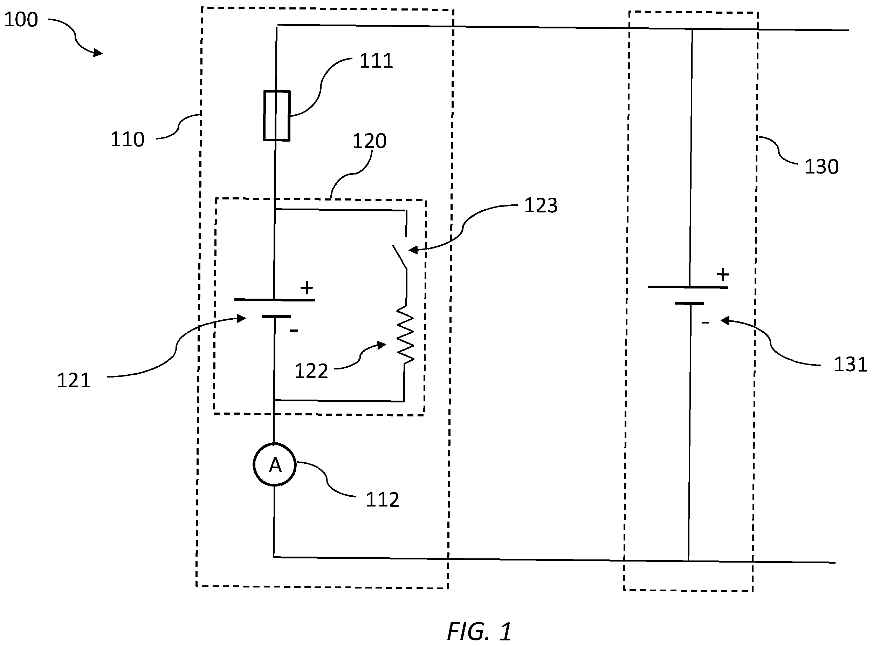

According to an embodiment of the present disclosure, a method for determining a state of a fuse in a battery pack is provided. With reference to FIG. 1, an example of a battery pack 100 is illustrated. The battery pack 100 comprises a first string 110. The first string 110 comprises a first string fuse 111 and a first ammeter 112. The first string 110 further comprises at least one parallel arrangement 120 comprising a battery cell 121 and a resistor 122. The parallel arrangement 120 is configured to be changeable between a connected state and a disconnected state (and vice versa). In the connected state the resistor 122 is connected in parallel to the battery cell 121, and in the disconnected state the resistor 122 is disconnected from the battery cell 121. An example is indicated in FIG. 1 whereby the parallel arrangement is changeable between the connected state and the disconnected state by actuating a switch 123. The switch 123 is shown as being open in FIG. 1. When the parallel arrangement 120 is in the disconnected state, the battery cell 121 is still connected in the first string 110, but the battery cell 121 does not have a resistor 122 connected across it. The first string fuse 111, the at least one parallel arrangement 120 and the first ammeter 112 are connected in series. The battery pack 100 further comprises a second string 130, the second string 130 comprising at least one battery cell 131.

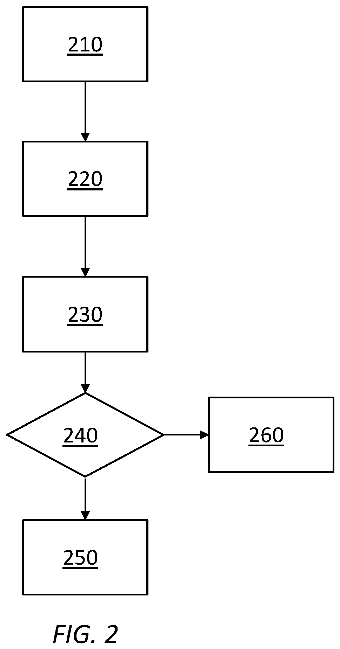

With reference to FIG. 2, the method for determining a state of the first string fuse 111 comprises changing the at least one parallel arrangement 120 of the first string 110 to the connected state at step 210. For example, switch 123 may be closed. At step 220, a first current passing through the first string 110 is measured using the first ammeter 112 during a first time period. The first time period occurs after the at least one parallel arrangement 120 is changed to the connected state. At step 230 it is determined whether a change in the first current during the first time period is greater than a threshold current change. In an event that the change in the first current during the first time period does not exceed the threshold current change at step 240, the method comprises providing a notification that the first string fuse 111 is in a blown state at step 250. In an event that the change in the first current during the first time period is greater than the threshold current change at step 240, the first string fuse 111 is determined to be intact at step 260.

After the first time period, the at least one parallel arrangement may be changed to the disconnected state, for example by opening switch 123.

Providing a notification that the first string fuse 111 is in a blown state may comprise one or more of notifying an operator, triggering an alarm or sound, turning on a light, providing a message on a display, recording the notification, communicating the notification to a server, or other means of notification. In an event that the change in the first current during the first time period does not exceed the threshold current change, the method may further comprise taking the first string offline.

When the parallel arrangement 120 is changed to be in the connected state at step 210, current flows within the parallel arrangement 120 as the battery cell 121 discharges through the resistor 122. As the first string 110 and the second string 130 are in parallel, the voltage across each string must balance. In order to achieve this, current flows to transfer charge from the battery cell 131 of the second string to the battery cell 121 of the first string. This can occur only if the first string 110 is complete (i.e. the first string fuse 111 is in tact), so that the first and second strings 110, 130 form a complete circuit. In an event that the first string fuse is not in tact, the current flow to transfer charge from the battery cell 131 of the second string to the battery cell 121 of the first string cannot occur, since there is no complete circuit between the first and second strings 110, 130. This will be described in more detail with reference to FIG.s 3 and 4.

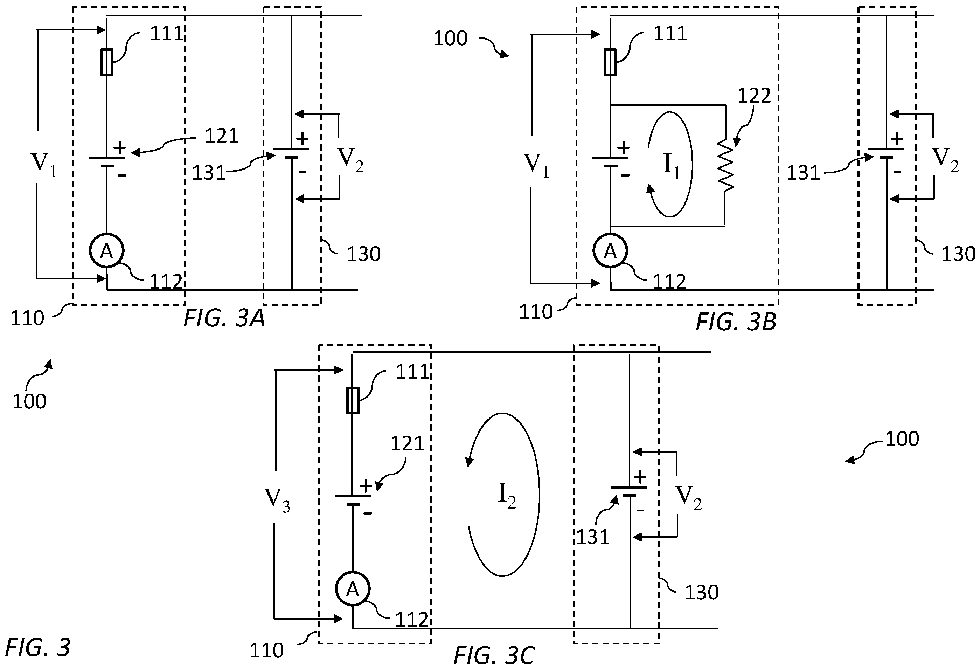

FIG. 3 shows the battery pack 100 with the first string fuse 111 in tact. FIG. 3A shows the circuit of the battery pack 100 when the parallel arrangement 120 is in the disconnected state, such that the resistor 122 is not connected in parallel with the first battery cell 121. The voltage across the first string 110 is *V*₁ and the voltage across the second string is *V*₂. As the first string 110 is in parallel with the second string 130, *V*₁ = *V*₂. At step 210, the parallel arrangement 120 is changed to the connected state, such that the resistor 122 is connected in parallel with the first battery cell 121 as shown in FIG. 3B. This creates a closed loop, and current *I*₁ flows, dissipating energy across the resistor 122 and reducing the voltage of the first battery cell 121. With reference to FIG. 3C, the potential difference across the first string 110 is now *V*₃ < *V*₁. The first string fuse 111 is in tact, so there is a closed loop between the first string 110 and the second string 130. Current *I*₂ flows to compensate for the imbalance in potential difference, such that the first battery cell 121 is charged by the second battery cell 131. *V*₃ is increased and *V*₂ is decreased, until the potential difference across the first string 110 is equal to the potential difference across the second string 130. The first ammeter 112 measures this current flow during the first time period.

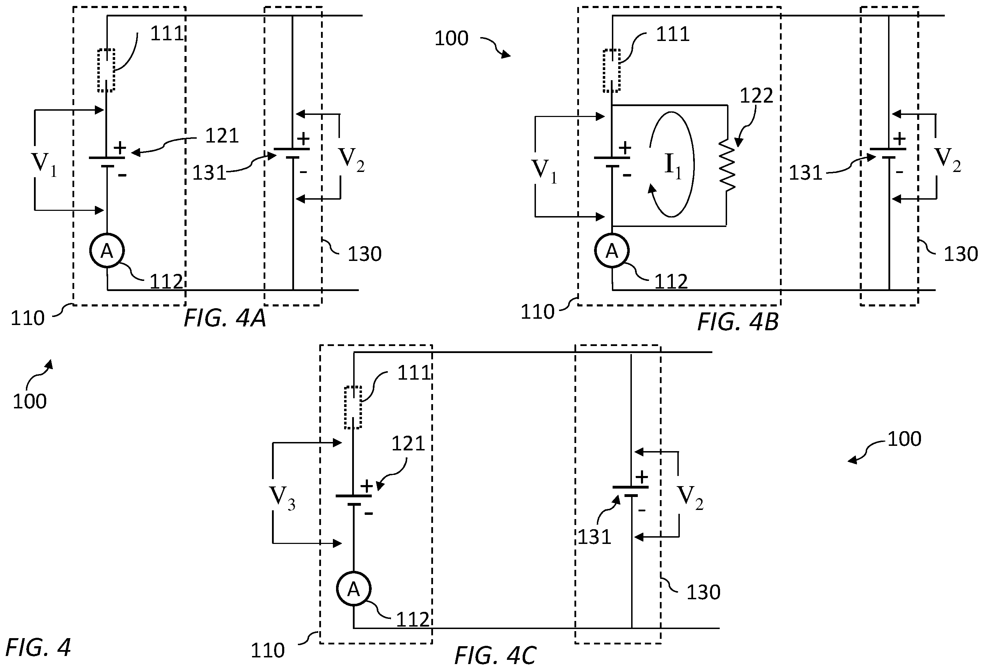

FIG. 4 shows the battery pack 100 with the first string fuse 111 broken. FIG. 4A shows the circuit of the battery pack 100 when the parallel arrangement 120 is in the disconnected state, such that the resistor 122 is not connected in parallel with the first battery cell 121. The voltage across the first battery cell 121 is *V*₁ and the voltage across the second string is *V*₂. At step 120, the parallel arrangement 120 is changed to the connected state, such that the resistor 122 is connected in parallel with the first battery cell 121 as shown in FIG. 4B. This creates a closed loop, and current *I*₁ flows, dissipating energy across the resistor 122 and reducing the voltage of the first battery cell 121. With reference to FIG. 4C, the potential difference across the first battery cell 121 is now *V*₃ < *V*₁. However, the first string fuse 111 is broken, so there is no closed loop between the first string 110 and the second string 130. Current cannot flow to compensate for the imbalance in potential difference between the first and second strings 110, 130, so there is no current measured on the first ammeter 112 during the first time period.

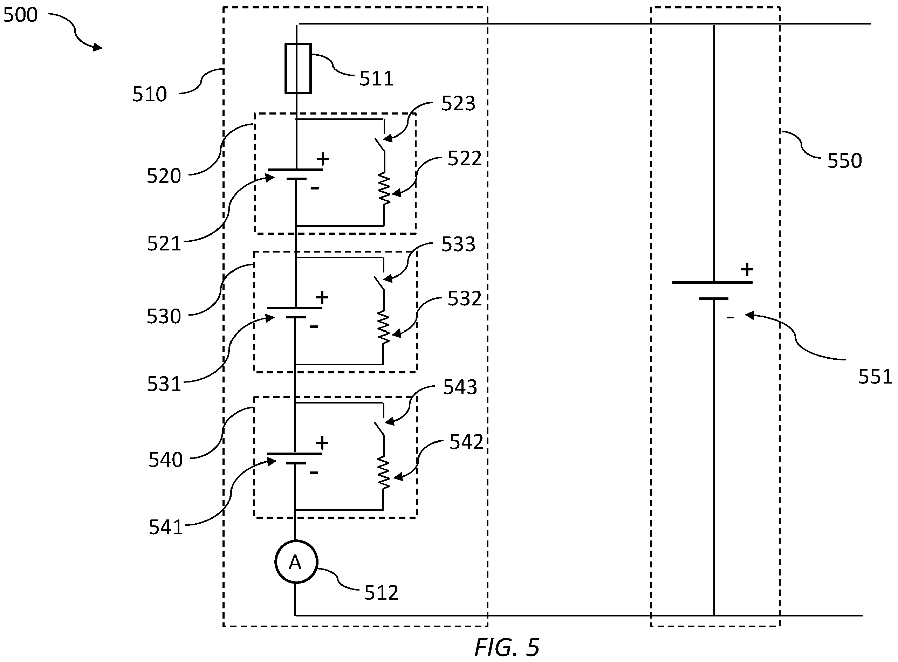

In certain embodiments, the first string may comprise two or more parallel arrangements connected in series. Each parallel arrangement comprises a battery cell and a resistor and each parallel arrangement is configured to be changeable between a connected state, wherein the resistor is connected in parallel to the battery cell, and a disconnected state, wherein the resistor is disconnected from the battery cell. With reference to FIG. 5, a battery pack 500 is illustrated, wherein the first string 510 comprises three parallel arrangements 520, 530 and 540. This an example, and the first string may comprise more than three parallel arrangements or fewer than three parallel arrangements. The battery pack 500 comprises a first string 510. The first string 510 comprises a first string fuse 511 and a first ammeter 512. The first string 510 further comprises a first parallel arrangement 520 comprising a battery cell 521 and a resistor 522. The parallel arrangement 520 is configured to be changeable between a connected state and a disconnected state. In the connected state the resistor 522 is connected in parallel to the battery cell 521, and in the disconnected state the resistor 522 is disconnected from the battery cell 521. An example is indicated in FIG. 5 whereby the parallel arrangement is changeable between the connected state and the disconnected state by actuating a switch 523. The switch 523 is shown as being open in FIG. 1. The first string 510 further comprises a second parallel arrangement 530 comprising a battery cell 531 and a resistor 532. The parallel arrangement 530 is configured to be changeable between a connected state and a disconnected state. In the connected state the resistor 532 is connected in parallel to the battery cell 531, and in the disconnected state the resistor 532 is disconnected from the battery cell 531. The first string 510 further comprises a third parallel arrangement 540 comprising a battery cell 541 and a resistor 542. The parallel arrangement 540 is configured to be changeable between a connected state and a disconnected state. In the connected state the resistor 542 is connected in parallel to the battery cell 541, and in the disconnected state the resistor 542 is disconnected from the battery cell 541. The first string fuse 511, the first parallel arrangement 520, the second parallel arrangement 530, the fourth parallel arrangement 540 and the first ammeter 512 are connected in series. The battery pack 500 further comprises a second string 550, the second string 550 comprising at least one battery cell 551.

The method described with reference to FIG. 2 may be carried out for the battery pack of FIG. 5. Step 210 may comprise changing each of the first, second and third parallel arrangements 520, 530 and 540 to the connected state at the same time, such that each of the battery cells 521, 522 and 523 start to discharge at the same time. In this way, each of the battery cells 521, 522 and 523 may discharge by a similar amount during the method. Similarly, in embodiments where the first string comprises a different number of parallel arrangements, the step 210 comprises changing each of the parallel arrangements to the connected state at the same time such that the battery cell of each parallel arrangement discharges at the same time. In other embodiments where the first string comprises a different number of parallel arrangements, step 210 may comprise changing each of the parallel arrangements to the connected state sequentially. In other embodiments where the first string comprises a different number of parallel arrangements, step 210 may comprise changing one or more of the parallel arrangements to the connected state, while the other parallel arrangement(s) remain in the disconnected state.

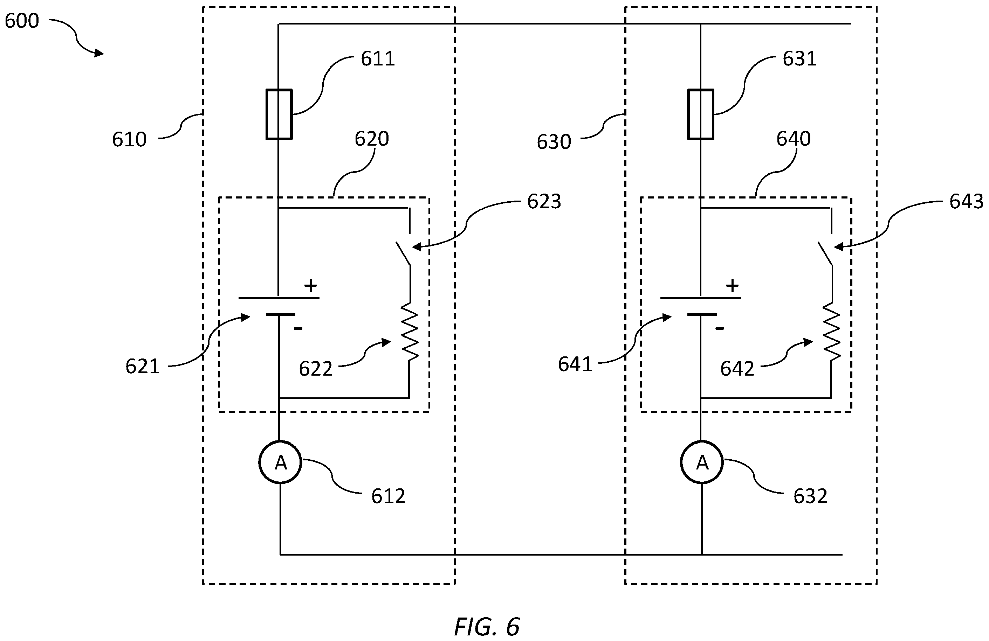

In certain embodiments, the second string of the battery pack may further comprise a second string fuse, a second ammeter and at least one parallel arrangement comprising a battery cell and a resistor. With reference to FIG. 6, a battery pack 600 comprises a first string 610. The first string 610 comprises a first string fuse 611 and a first ammeter 612. The first string 610 further comprises at least one parallel arrangement 620 comprising a battery cell 621 and a resistor 622. The parallel arrangement 620 is configured to be changeable between a connected state and a disconnected state. In the connected state the resistor 622 is connected in parallel to the battery cell 621, and in the disconnected state the resistor 622 is disconnected from the battery cell 621. An example is indicated in FIG. 6 whereby the parallel arrangement is changeable between the connected state and the disconnected state by actuating a switch 623. The switch 623 is shown as being open in FIG. 6. The first string fuse 611, the at least one parallel arrangement 620 of the first string and the first ammeter 612 are connected in series. The battery pack 600 further comprises a second string 630. The second string 630 comprises a second string fuse 631 and a second ammeter 632. The second string 630 further comprises at least one parallel arrangement 640 comprising a battery cell 641 and a resistor 642. The parallel arrangement 640 is configured to be changeable between a connected state and a disconnected state. In the connected state the resistor 642 is connected in parallel to the battery cell 641, and in the disconnected state the resistor 642 is disconnected from the battery cell 641. An example is indicated in FIG. 6 whereby the parallel arrangement is changeable between the connected state and the disconnected state by actuating a switch 643. The switch 643 is shown as being open in FIG. 6. The second string fuse 631, the at least one parallel arrangement 640 of the second string, and the second ammeter 632 are connected in series.

In certain embodiments, the method of determining a state of a fuse of the battery pack 600 comprises determining a state of the first string fuse 611 and determining a state of the second string fuse 631. Determining a state of the first string fuse 611 comprises changing the at least one parallel arrangement 620 of the first string 610 to the connected state. For example, switch 623 may be closed. The at least one parallel arrangement 640 of the second string 630 is in the disconnected state. A first current passing through the first string 610 is measured using the first ammeter 612 during a first time period. The first time period occurs after the at least one parallel arrangement 620 of the first string 610 is changed to the connected state. It is determined whether a change in the first current during the first time period is greater than a threshold current change. In an event that the change in the first current during the first time period does not exceed the threshold current change, the method comprises providing a notification that the first string fuse 611 is in a blown state. In an event that the change in the first current during the first time period is greater than the threshold current change, the first string fuse 611 is determined to be intact. The at least one parallel arrangement 620 of the first string 610 is changed to the disconnected state. The method further comprises determining a state of the second string fuse 631. The at least one parallel arrangement 640 of the second string 630 is changed to the connected state. For example, switch 643 may be closed. The at least one parallel arrangement 620 of the first string 610 is in the disconnected state. A second current passing through the second string 630 is measured using the second ammeter 632 during a second time period. The second time period occurs after the at least one parallel arrangement 640 of the second string 630 is changed to the connected state. It is determined whether a change in the second current during the second time period is greater than a threshold current change. In an event that the change in the second current during the second time period does not exceed the threshold current change, the method comprises providing a notification that the second string fuse 631 is in a blown state. In an event that the change in the second current during the second time period is greater than the threshold current change, the second string fuse 631 is determined to be intact. The at least one parallel arrangement 640 of the second string 630 is changed to the disconnected state.

One or both of the first string 610 and the second string 630 may comprise more than one parallel arrangement, wherein the more than one parallel arrangements are connected in series.

In certain embodiments, the battery pack may further comprise at least one additional string connected in parallel to the first string and the second string. Each additional string may be similar to the first or second string, such that each additional string comprises a string fuse, an ammeter and at least one parallel arrangement comprising a battery cell and resistor. The at least one parallel arrangement is configured to be changeable between A connected state wherein the resistor is connected in parallel to the battery cell; and a disconnected state wherein the resistor is disconnected from the battery cell. The ammeter, the string fuse, the at least one parallel arrangement of each additional string are connected in series. For each additional string, the method further comprises determining a state of the string fuse of the additional string, using the method outlined above. Determining a state of the string fuse for a given string comprises changing the at least one parallel arrangement of that string to the connected state, wherein the parallel arrangements of all other strings are in the disconnected state. A current passing through the given string is measured using the ammeter of that string during a time period after changing the at least one parallel arrangement of that string to the connected state. It is determined whether a change in the current during the time period is greater than a threshold current change. In an event that the change in the current during the time period does not exceed the threshold current change, the method comprises providing a notification that the string fuse of the additional string is in a blown state. In an event that the change in the current during the time period is greater than the threshold current change, the string fuse of the additional string is determined to be intact. This may be repeated for each string.

In embodiments where the method comprises determining a state of a fuse of more than one string, determining the state of the fuse of each string may be carried out sequentially.

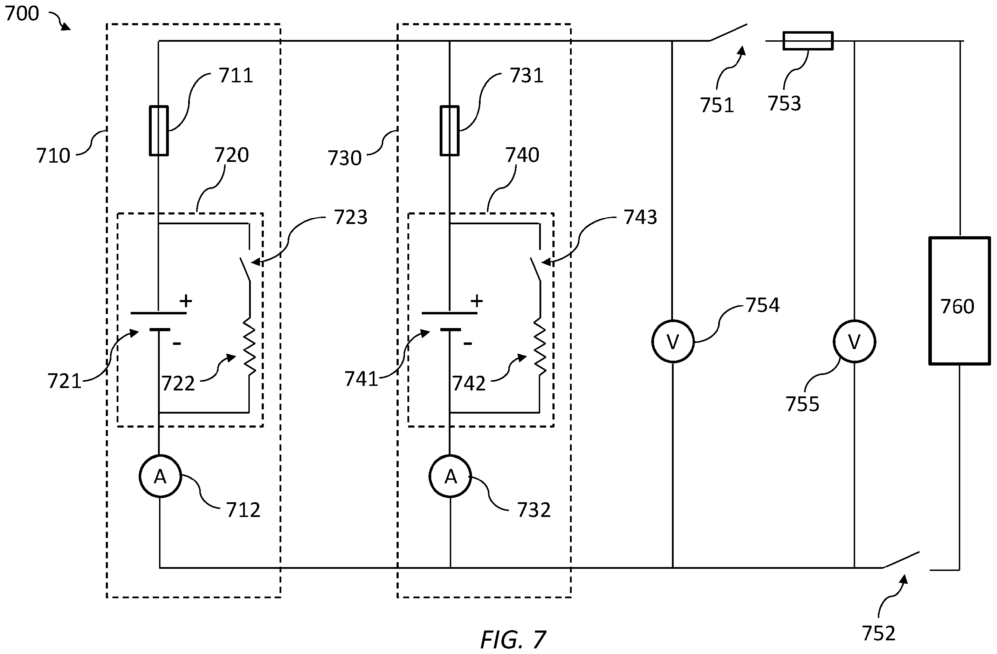

In certain embodiments, the methods outlined above may be carried out when the battery pack is in standby mode. There may be no load connected to the battery pack, such that the only closed circuits may be between strings of the battery pack or when the parallel arrangement(s) are in a connected state. The battery may be in closed circuit, to the extent that the fuse(s) are in tact, but any electrical loads do not draw current from the battery in a standby state. The methods outlined above may be carried out when a main contactor of the battery is open (such that the battery is disconnected from the load). For example, FIG. 7 shows a battery pack similar to that illustrated in FIG. 6, wherein the battery pack 700 is connectable to a load 760 via main contactors 751 and 752. The methods outlined above may be carried out when one or both of main contactors 751 and 752 may be open. In certain embodiments, main contactor 751 may comprise a positive contactor and main contactor 752 may comprise a negative contactor.

In certain embodiments, the battery pack may be configured to power an electric vehicle. The methods outlined above may be carried out at key on of the electric vehicle. The methods outlined above may be carried out at key off of the electric vehicle.

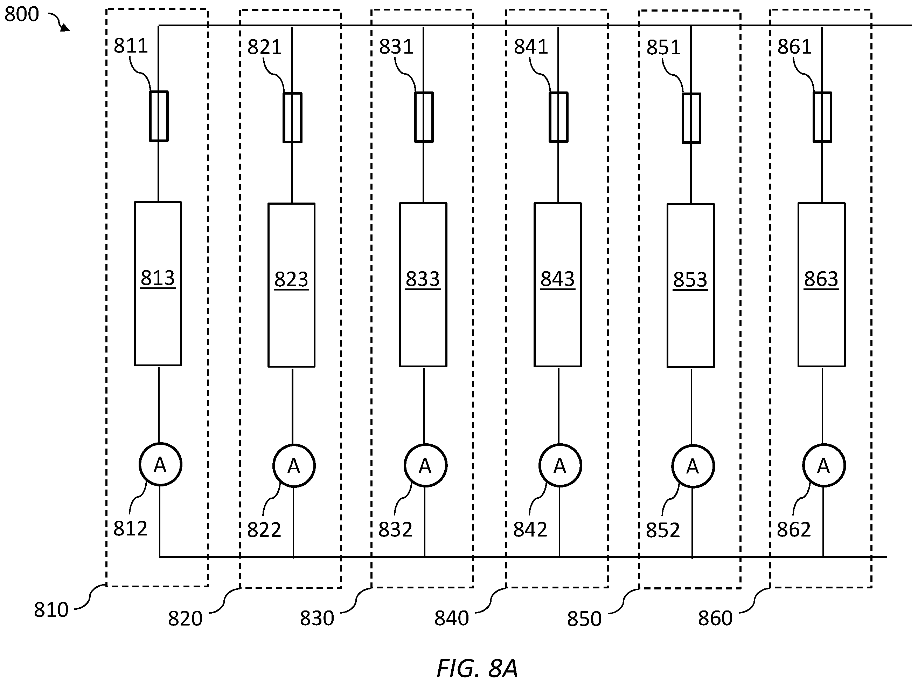

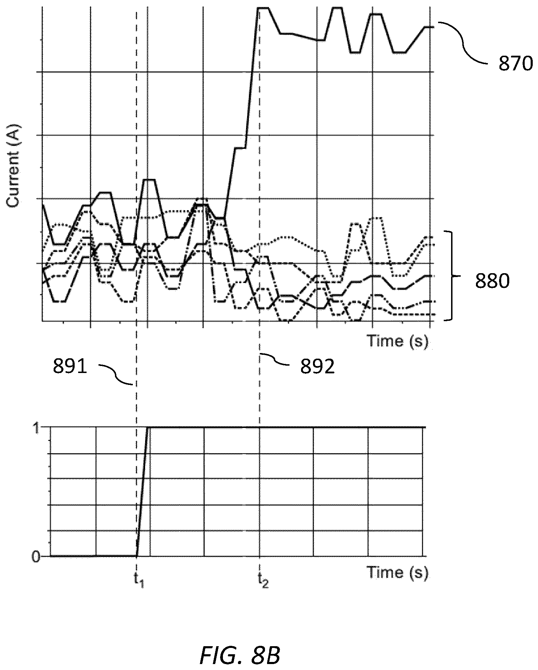

FIG. 8 shows an example of current measurements for six strings of a battery pack while carrying out a method according to an embodiment of the disclosure. FIG. 8A shows six strings 810, 820, 830, 840, 850 and 860 of a battery pack 800, wherein the six strings 810, 820, 830, 840, 850 and 860 are connected in parallel. Each string may comprise a string fuse 811, 821, 831, 841, 851 and 862. Each string further comprises an ammeter 812, 822, 832, 842, 852 and 862. Each string may further comprise one or more parallel arrangements, indicated by 813, 823, 833, 843, 853 and 863. The graphs illustrate current measurements while determining a state of a first string fuse 811 of a first string 810. The upper graph shows current plotted against time for each of the six strings. The lower graph shows the state of the parallel arrangement(s), wherein 1 is the connected state and 0 is the disconnected state. The upper and lower graphs are shown with the same time scale on the x-axes. At time t1, indicated by the left hand vertical dashed line 891, the parallel arrangement(s) of the first string are changed to be in the connected state. In this example, the first time period is between t1 and t2, where t2 is shown by the right hand vertical dashed line 892. The current passing through the first string is plotted as solid line 870. The current passing through the other five strings are shown as dashed and dotted lines (indicated by bracket 880). It can be seen that the current passing through the first string increases significantly during the first time period, indicating that current is flowing to compensate for the dissipated charge and so the first fuse is in tact.

The methods described above make use of a resistor that can be connected in parallel with a battery cell and disconnected from the battery cell. As discussed, these methods may be appropriate when the battery pack is not in use. Further methods may be used to determine a state of a fuse while the battery pack is running. One or more of the following methods may be used in addition to the methods described above. The following methods may be carried out continuously while the battery pack is running, or may be carried out periodically.

In certain embodiments, a method of determining a state of a string fuse of a battery pack while the battery pack is in use may comprise comparing the string current to a pack current. In an event that for a period of time longer than a threshold time the current of the battery pack is above a pack threshold and the current of the connected string is below a string threshold, the method further comprises notifying an operator that the string fuse of the string is in a blown state.

In certain embodiments, the battery pack may further comprise a battery pack fuse, such as the battery pack fuse 753 illustrated in FIG. 7. The method may further comprise determining a status of the battery pack fuse by comparing a bus voltage (or machine-side voltage) and a battery pack voltage when the battery pack is online (main contactors are closed). The bus voltage may be measured using voltmeter 755, and the battery pack voltage may be measured using voltmeter 754. In an event that a difference between the bus voltage and the battery pack voltage is above a voltage threshold for a period of time longer than a threshold time, the method further comprises providing a notification that the battery pack fuse is in a blown state.

In certain embodiments, the battery pack may further comprise a battery pack fuse and the battery pack may be included in a multi-pack battery comprising at least one additional battery pack. The method may further comprise determining a status of a battery pack fuse. For each battery pack, the method may comprise comparing a current of each connected battery pack of the multi-pack battery to a current of the multi-pack battery, wherein in an event that the current of the multi-pack battery is above a battery current threshold and the current of the battery pack is below a pack current threshold, the method further comprises providing a notification that the battery pack fuse is in a blown state.

The methods described herein determine the state of a fuse. The battery pack current limits may be determined by the number of connected strings of the battery pack. In an event that it is determined that a string fuse is in a blown state, the method may further comprise adjusting the current limit(s) for the battery pack, based on the number of strings that are online and do not have a blown fuse. Similarly, the current limit for a multi-pack battery may depend on the number of connected battery packs of the multi-pack batteries. In an event that a method determines that the battery pack fuse is in a blown state, the method may further comprise adjusting the current limit for the multi-pack battery.

The methods of determining the state of a string fuse described above comprise measuring a current during a time period, wherein the time period occurs after the at least one parallel arrangement of the string fuse is changed to the connected state. The time period may be triggered by the at least one parallel arrangement of the string fuse is changing to the connected state. The time period may begin when the least one parallel arrangement of the string fuse is changed to the connected state. The time period may begin at a fixed time after least one parallel arrangement of the string fuse is changed to the connected state. The time period may be a fixed length of time.

In certain embodiments, in an event that a fuse is found to be in tact by one of the above methods, no action may be taken. In other embodiments, in an event that a fuse is found to be in tact by one of the above methods, a user may be notified.

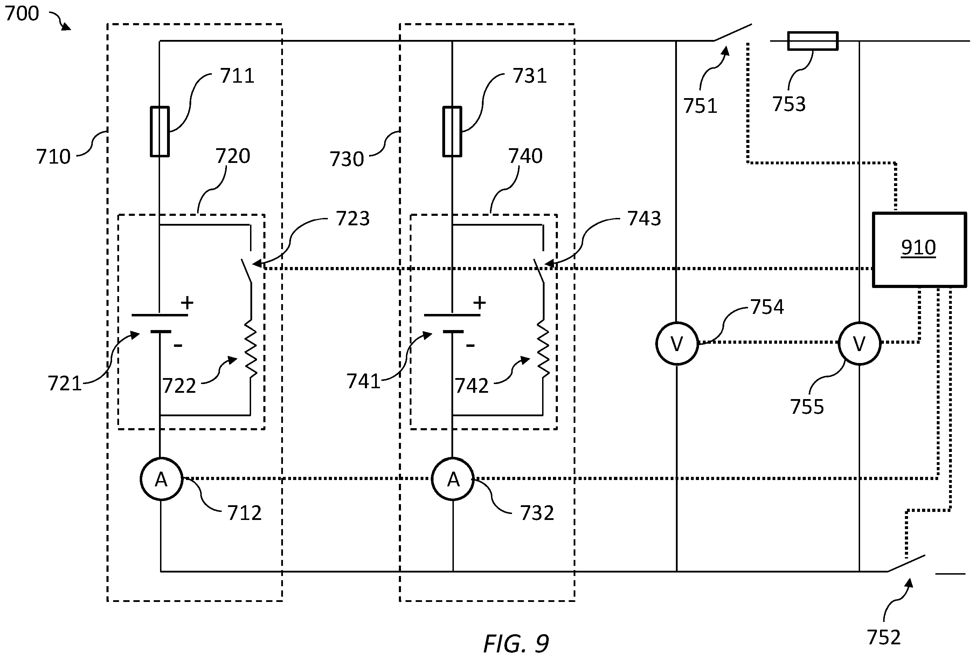

According to an embodiment, a battery management system is provided wherein the battery management system is configured to carry out the method of any preceding claim. With reference to FIG. 9, an example of a battery management system (BMS) 910 is shown for the battery pack 700 of FIG. 7. The BMS 910 may be communicably connected to the voltmeters 754 and 755 and the ammeters 712 and 732, wherein the BMS 910 is conjured to determine voltage and current from the voltmeters 754, 755 and the ammeters 712, 732, respectively. The BMS 910 may be communicably connected to each battery cell, and may be configured to sense cell voltage and temperature. The BMS 910 may be configured to control the state of each parallel arrangement, such that the BMS 910 is configured to change each parallel arrangement between the connected and disconnected state and vice versa. The BMS 910 may be further configured to control contactors 751 and 752. A BMS may be used with any of the battery packs described herein. The BMS may be configured to sense voltage and current, to control contactors, and to sense other properties of the battery cells.

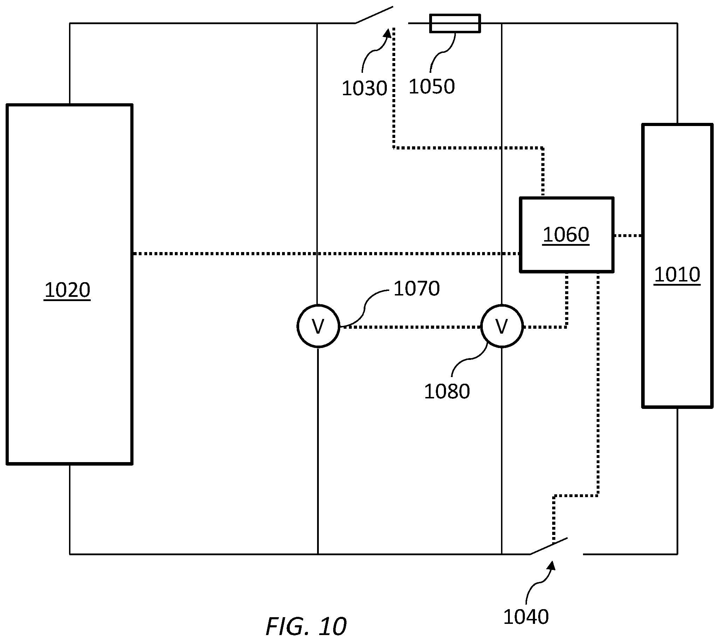

According to an embodiment, a machine is provided, wherein the machine comprises an electrical load and a battery pack coupled to the electrical load. For example, with reference to FIG. 10, the machine may comprise an electrical load 1010 and a battery pack 1020. The battery pack may be connected to or disconnected from the electrical load 1010 via main contactors 1030 and 1040, and may comprise a battery pack fuse 1050. A battery management system 1060 may be connected to the battery pack 1020, contactors 1030 and 1040, the electrical load 1010, and voltmeters 1070 and 1080. The battery pack 1020 comprises a first string comprising a first string fuse, a first ammeter and at least one parallel arrangement comprising a battery cell and a resistor. The parallel arrangement is configured to be changeable between a connected state wherein the resistor is connected in parallel to the battery cell; and a disconnected state wherein the resistor is disconnected from the battery cell. The first string fuse, the at least one parallel arrangement and the first ammeter are connected in series. The battery pack 1020 further comprises a second string connected in parallel to the first string, the second string comprising at least one battery cell. The battery management system 1060 is configured to carry out the method of any preceding claim. The battery pack 1020 may comprise any battery pack described herein.

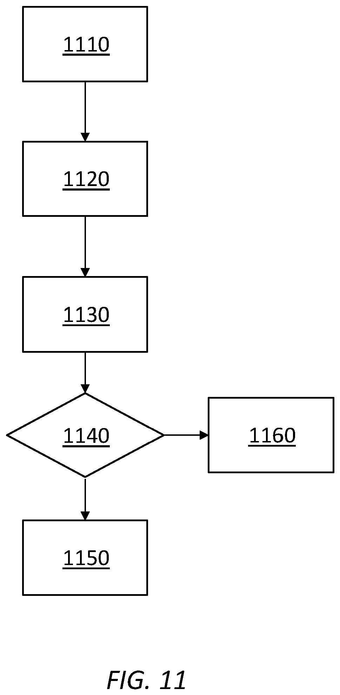

According to certain embodiments, the methods described above may be used to detect whether a circuit is open or closed. For example, there may be a fault other than a broken or short-circuited fuse that can result in an open circuit. For example, a switch or contactor may fail, or a wire may break. With reference to FIG. 11, according to certain embodiments a method may be provided of detecting the presence or absence of an open circuit in a battery pack. The battery pack comprises a first string comprising a first ammeter and at least one parallel arrangement comprising a battery cell and a resistor. The parallel arrangement is configured to be changeable between a connected state wherein resistor is connected in parallel to the battery cell; and a disconnected state wherein the resistor is disconnected from the battery cell. The at least one parallel arrangement and the first ammeter are connected in series. The battery pack further comprises a second string connected in parallel to the first string, the second string comprising at least one battery cell. The method comprises changing the at least one parallel arrangement to the connected state at step 1110. At step 1120 the method comprises measuring a first current passing through the first string using the first ammeter during a first time period after the at least one parallel arrangement is changed to the connected state. At step 1130 the method comprises determining whether a change in the first current during the first time period is greater than a threshold current change. In an event that the change in the first current during the first time period does not exceed the threshold current change at step 1140, the method comprises providing a notification that the first string comprises a break in the circuit at step 1150. In an event that the change in the first current during the first time period is greater than the threshold current change at step 1140, the first string is determined to be intact at step 1160.

As described above, in certain embodiments a string of a battery pack may comprise more than one parallel arrangement in series. For instance, the battery pack 500 illustrates a first string comprising more than one parallel arrangement in series. The resistor of each parallel arrangement may be used as a balancing resistor. In an event that there is an imbalance between the more than one battery cells of the string, one or more of the parallel arrangements may be changed to the connected state. Changing a parallel arrangement to the connected state allows the battery cell of the parallel arrangement to discharge via the resistor. This can be used to reduce the state of charge of one or more of the battery cells until the state of charge of each battery cell is equal. For example, if a battery cell of a first parallel arrangement has a higher state of charge than the other battery cells of the string, the first parallel arrangement may be changed to the connected state such that the battery cell begins to discharge. When the battery cell of that string reaches the state of charge of the other battery cells of that string, the parallel arrangement may be changed to the disconnected state. These balancing resistors may be already present in battery packs, and may be implemented to carry out the methods described herein for determining the state of the string fuse.

### Industrial Applicability

The methods described herein comprise determining a state of the first string fuse by changing the at least one parallel arrangement of the first string to the connected state. Changing a parallel arrangement to the connected state has the effect of creating a closed circuit including the resistor and the battery cell of the parallel arrangement, such that energy from the battery cell is dissipated via the resistor. The potential difference of the first string decreases, as the battery cell of each of the at least one parallel arrangements discharges. This may be achieved using existing resistors in a battery pack, since many battery packs comprise resistors in parallel with each battery cell. For instance, these resistors may be used for cell balancing.

The methods described herein further comprise measuring a first current passing through the first string using the first ammeter during a first time period after the at least one parallel arrangement is changed to the connected state. If the first string is in tact then it is connected in a parallel circuit with at least one other string. As the potential difference of the first string has decreased, current will flow to increase the potential difference of the first string (i.e. charge the battery cell(s) of the first string) such that the potential differences of the strings are equal. If the first string is not in tact, current will not be able to flow to compensate for the dissipation. Therefore, whether or not an increase in current is measured provides information as to whether the first string is in tact. In this way, the state of the first string fuse may be determined using the existing string ammeter, which is present in many battery packs and is monitored by a battery management system.

This allows a state of the fuse to be determined before the battery is connected to a load, since no power is required. In an event that a fuse is determined to be broken, the current limits for the battery pack or any other battery pack may be adjusted before the battery is connected to a load, preventing overloading the other strings and/or any other battery packs. The above methods allow a rapid and reliable determination of the state of the first string fuse. Furthermore, the method may allow a state of a string fuse to be determined for a string having one string fuse and more than one battery cell, so only one fuse is required per string.

In certain embodiments, the methods described herein may be used for a vehicle or work machine. The methods of determining a state of a fuse may be carried out at key ON of the vehicle or machine, such that in an event that the fuse is broken action may be taken before the load of the vehicle or machine is connected to the battery pack. In an event that a fuse of a string is broken, the string may be taken offline and the current limit of the battery pack may be adjusted, allowing the vehicle or machine to be safely used without losing operation time. An operator may be notified, either locally or remotely, such that maintenance may be carried out on the battery to remedy the broken fuse or open circuit. Otherwise, the issue may be logged such that during routine maintenance the broken fuse or open circuit may be fixed.

## Claims

1. A method for determining a state of a fuse in a battery pack (100), wherein the battery pack (100) comprises:
a first string (110) comprising:
a first string fuse (111);
at least one parallel arrangement (120) comprising a battery cell (121) and a resistor (122), wherein the parallel arrangement (120) is configured to be changeable between:
a connected state wherein the resistor (122) is connected in parallel to the battery cell (121); and
a disconnected state wherein the resistor (122) is disconnected from the battery cell (121); and
a first ammeter (112), wherein the first string fuse (111), the at least one parallel arrangement (120) and the first ammeter (112) are connected in series; and
a second string (130) connected in parallel to the first string (110), the second string (130) comprising at least one battery cell (131);
the method comprising determining a state of the first string fuse (111) by:
changing the at least one parallel arrangement (120) of the first string (110) to the connected state;
measuring a first current passing through the first string (110) using the first ammeter (112) during a first time period after the at least one parallel arrangement (120) is changed to the connected state;
determining whether a change in the first current during the first time period is greater than a threshold current change; and
in an event that the change in the first current during the first time period does not exceed the threshold current change, providing a notification that the first string fuse (111) is in a blown state;
wherein in an event that the change in the first current during the first time period is greater than the threshold current change, the first string fuse (111) is determined to be intact.

2. The method of claim 1, wherein the first string (110) comprises at least two parallel arrangements connected in series, wherein each parallel arrangement comprises a battery cell and a resistor and wherein each parallel arrangement is configured to be changeable between a connected state wherein the resistor is connected in parallel to the battery cell and a disconnected state wherein the resistor is disconnected from the battery cell.

3. The method of claim 2, wherein the method comprises changing the at least two parallel arrangements to the connected state.

4. The method of claim 1, wherein the second string (630) comprises:
a second string fuse (631);
at least one parallel arrangement (640) comprising a battery cell (641) and a resistor (642), wherein the parallel arrangement (640) is configured to be changeable between:
a connected state wherein the resistor (642) is connected in parallel to the battery cell (641); and
a disconnected state wherein the resistor (642) is disconnected from the battery cell (641); and
a second ammeter (632), wherein the second string fuse (631), the at least one parallel arrangement (640) of the second string (630) and the second ammeter (632) are connected in series;
the method further comprising determining a state of the second string fuse (631) by:
changing the at least one parallel arrangement (640) of the second string (630) to the connected state;
measuring a second current passing through the first string (610) using the second ammeter (632) during a second time period after the at least one parallel arrangement (640) of the second string (630) is changed to the connected state;
determining whether a change in the second current during the second time period is greater than a threshold current change;
in an event that the change in the second current during the second time period does not exceed the threshold current change, providing a notification that the second string fuse (631) is in a blown state; and
wherein in an event that the change in the second current during the second time period is greater than the threshold current change, the second string fuse (631) is determined to be intact.

5. The method of claim 4, wherein:
the battery pack further comprises at least one additional string connected in parallel to the first string and the second string, each additional string comprising:
a string fuse;
at least one parallel arrangement comprising a battery cell and a resistor, wherein the parallel arrangement is configured to be changeable between:
a connected state wherein the resistor is connected in parallel to the battery cell; and
a disconnected state wherein the resistor is disconnected from the battery cell; and
an ammeter, wherein the string fuse, the at least one parallel arrangement and the ammeter of each additional string are connected in series; and
for each additional string, the method further comprises determining a state of the string fuse of the additional string by:
changing the at least one parallel arrangement of the additional string to the connected state;
measuring a current passing through the additional string using the ammeter of the additional string during an additional time period after changing the at least one parallel arrangement of the additional string to the connected state;
determining whether a change in the current during the additional time period is greater than a threshold current change;
in an event that the change in the current during the additional time period does not exceed the threshold current change, providing a notification that the string fuse of the additional string is in a blown state; and
wherein in an event that the change in the current during the additional time period is greater than the threshold current change, the string fuse of the additional string is determined to be intact.

6. The method of claim 5, wherein each string comprises more than one parallel arrangement.

7. The method of claim 4 wherein determining the state of the first string fuse and determining the state of the second string fuse occur sequentially.

8. The method of claim 5 wherein determining the state of the first string fuse, second string fuse and the string fuse of each additional string occurs sequentially.

9. The method of claim 1, wherein determination of the state of the first string fuse (111) is carried out when the battery pack is in standby mode.

10. The method of claim 8, wherein determination of the state of the first string fuse, the second string fuse and the third string fuse is carried out when the battery pack is in standby mode.

11. The method of claim 9, wherein the battery pack (100) is configured to power an electric vehicle and wherein the method is carried out at a key ON state of the electric vehicle.

12. The method of claim 1, further comprising comparing a current of each connected string of the battery pack string to a current of the battery pack, wherein in an event that for a period of time longer than a threshold time the current of the battery pack is above a pack threshold and the current of the connected string is below a string threshold the method further comprises providing a notification that the string fuse of the string is in a blown state.

13. The method of claim 1 wherein the battery pack further comprises a battery pack fuse (753), the method further comprising determining a status of the battery pack fuse (753) by comparing a bus voltage and a battery pack voltage, wherein in an event that a difference between the bus voltage and the battery pack voltage is above a voltage threshold for a period of time longer than a threshold time, the method further comprises providing a notification that the battery pack fuse (753) is in a blown state.

14. The method of claim 1 wherein the battery pack (700) further comprises a battery pack fuse (753) and wherein the battery pack (700) is included in a multi-pack battery comprising at least one additional battery pack, the method further comprising comparing a current of each connected battery pack of the multi-pack battery to a current of the multi-pack battery, wherein in an event that the current of the multi-pack battery is above a battery current threshold and the current of the battery pack is below a pack current threshold, the method further comprises notifying an operator that the battery pack fuse (753) is in a blown state.

15. The method of claim 12 wherein the step of comparing a current of each string to a current of the battery pack (700) is carried out continuously while the battery pack (700) is online.

16. The method of claim 1, wherein in an event that a string fuse is in a blown state the method further comprises adjusting a current limit of the battery pack.

17. The method of claim 13, wherein in an event that the battery pack fuse (753) is in a blown state the method further comprises adjusting a current limit of the multi-pack battery.

18. A battery management system (1060) configured to carry out the method of claim 1, wherein the battery management system comprises a controller communicably coupled to the at least one parallel arrangement and the first ammeter.

19. A machine comprising:
an electrical load (1010);
a battery pack (1020) coupled to the electrical load (1010), the battery pack (1020) comprising:
a first string comprising:
a first string fuse;
at least one parallel arrangement comprising a battery cell and a resistor, wherein the parallel arrangement is configured to be changeable between:
a connected state wherein the resistor is connected in parallel to the battery cell; and
a disconnected state wherein the resistor is disconnected from the battery cell; and
a first ammeter, wherein the first string fuse, the at least one parallel arrangement and the first ammeter are connected in series; and
a second string connected in parallel to the first string, the second string comprising at least one battery cell; and
a battery management system (1060) configured to carry out the method of claim 1.

20. A method of detecting the presence or absence of an open circuit in a battery pack, wherein the battery pack comprises:
a first string comprising:
at least one parallel arrangement comprising a battery cell and a resistor, wherein the parallel arrangement is configured to be changeable between:
a connected state wherein resistor is connected in parallel to the battery cell; and
a disconnected state wherein the resistor is disconnected from the battery cell; and
a first ammeter, wherein the at least one parallel arrangement and the first ammeter are connected in series; and
a second string connected in parallel to the first string, the second string comprising at least one battery cell;
the method comprising:
changing the at least one parallel arrangement to the connected state (1110);
measuring a first current passing through the first string using the first ammeter during a first time period after the at least one parallel arrangement is changed to the connected state (1120);
determining whether a change in the first current during the first time period is greater than a threshold current change (1130); and
in an event that the change in the first current during the first time period does not exceed the threshold current change, providing a notification that the first string comprises a break in the circuit (1150);
wherein in an event that the change in the first current during the first time period is greater than the threshold current change, the first string is determined to be intact (1160).

## Patentansprüche

1. Verfahren zum Bestimmen eines Zustands einer Sicherung in einem Batteriepack (100), wobei das Batteriepack (100) Folgendes umfasst:
einen ersten Strang (110), umfassend:
eine erste Strangsicherung (111);
mindestens eine Parallelanordnung (120), die eine Batteriezelle (121) und einen Widerstand (122) umfasst, wobei die Parallelanordnung (120) konfiguriert ist, um änderbar zu sein zwischen:
einem verbundenen Zustand, wobei der Widerstand (122) parallel zu der Batteriezelle (121) verbunden ist; und
einem getrennten Zustand, wobei der Widerstand (122) von der Batteriezelle (121) getrennt ist; und
ein erstes Amperemeter (112), wobei die erste Strangsicherung (111), die mindestens eine Parallelanordnung (120) und das erste Amperemeter (112) in Reihe verbunden sind; und
einen zweiten Strang (130), der parallel zu dem ersten Strang (110) verbunden ist, wobei der zweite Strang (130) mindestens eine Batteriezelle (131) umfasst;
das Verfahren umfassend Bestimmen eines Zustands der ersten Strangsicherung (111) durch:
Ändern der mindestens einen Parallelanordnung (120) des ersten Strangs (110) in den verbundenen Zustand;
Messen eines durch den ersten Strang (110) fließenden ersten Stroms unter Verwendung des ersten Amperemeters (112) während einer ersten Zeitspanne, nachdem die mindestens eine Parallelanordnung (120) in den verbundenen Zustand geändert ist;
Bestimmen, ob eine Änderung des ersten Stroms während der ersten Zeitspanne größer als eine Schwellenwertstromänderung ist; und
in einem Fall, in dem die Änderung des ersten Stroms während der ersten Zeitspanne die Schwellenwertstromänderung nicht überschreitet, Bereitstellen einer Benachrichtigung, dass die erste Strangsicherung (111) in einem durchgebrannten Zustand ist;
wobei, in einem Fall, in dem die Änderung des ersten Stroms während der ersten Zeitspanne größer als die Schwellenwertstromänderung ist, die erste Strangsicherung (111) als intakt bestimmt wird.

2. Verfahren nach Anspruch 1, wobei der erste Strang (110) mindestens zwei in Reihe verbundene Parallelanordnungen umfasst, wobei jede Parallelanordnung eine Batteriezelle und einen Widerstand umfasst und wobei jede Parallelanordnung konfiguriert ist, um zwischen einem verbundenen Zustand, wobei der Widerstand parallel zu der Batteriezelle verbunden ist, und einem getrennten Zustand, wobei der Widerstand von der Batteriezelle getrennt ist, änderbar zu sein.

3. Verfahren nach Anspruch 2, wobei das Verfahren das Ändern der mindestens zwei Parallelanordnungen in den verbundenen Zustand umfasst.

4. Vorrichtung nach Anspruch 1, wobei der zweite Strang (630) Folgendes umfasst:
eine zweite Strangsicherung (631);
mindestens eine Parallelanordnung (640), die eine Batteriezelle (641) und einen Widerstand (642) umfasst, wobei die Parallelanordnung (640) konfiguriert ist, um änderbar zu sein zwischen:
einem verbundenen Zustand, wobei der Widerstand (642) parallel zu der Batteriezelle (641) verbunden ist; und
einem getrennten Zustand, wobei der Widerstand (642) von der Batteriezelle (641) getrennt ist; und
ein zweites Amperemeter (632), wobei die zweite Strangsicherung (631), die mindestens eine Parallelanordnung (640) des zweiten Strangs (630) und das zweite Amperemeter (632) in Reihe verbunden sind;
das Verfahren ferner umfassend Bestimmen eines Zustands der zweiten Strangsicherung (631) durch:
Ändern der mindestens einen Parallelanordnung (640) des zweiten Strangs (630) in den verbundenen Zustand;
Messen eines durch den ersten Strang (610) fließenden zweiten Stroms unter Verwendung des zweiten Amperemeters (632) während einer zweiten Zeitspanne, nachdem die mindestens eine Parallelanordnung (640) des zweiten Strangs (630) in den verbundenen Zustand geändert ist;
Bestimmen, ob eine Änderung des zweiten Stroms während der zweiten Zeitspanne größer als eine Schwellenwertstromänderung ist;
in einem Fall, in dem die Änderung des zweiten Stroms während der zweiten Zeitspanne die Schwellenwertstromänderung nicht überschreitet, Bereitstellen einer Benachrichtigung, dass die zweite Strangsicherung (631) in einem durchgebrannten Zustand ist; und
wobei in einem Fall, in dem die Änderung des zweiten Stroms während der zweiten Zeitspanne größer als die Schwellenwertstromänderung ist, die zweite Strangsicherung (631) als intakt bestimmt wird.

5. Verfahren nach Anspruch 4, wobei:
das Batteriepack ferner mindestens einen zusätzlichen Strang umfasst, der parallel zu dem ersten Strang und dem zweiten Strang verbunden ist, wobei jeder zusätzliche Strang Folgendes umfasst:
eine Strangsicherung;
mindestens eine Parallelanordnung, die eine Batteriezelle und einen Widerstand umfasst, wobei die Parallelanordnung konfiguriert ist, um änderbar zu sein zwischen:
einem verbundenen Zustand, wobei der Widerstand parallel zu der Batteriezelle verbunden ist; und
einem getrennten Zustand, wobei der Widerstand von der Batteriezelle getrennt ist; und
ein Amperemeter, wobei die Strangsicherung, die mindestens eine Parallelanordnung und das Amperemeter jedes zusätzlichen Strangs in Reihe verbunden sind; und
für jeden zusätzlichen Strang das Verfahren ferner das Bestimmen eines Zustands der Strangsicherung des zusätzlichen Strangs durch Folgendes umfasst:
Ändern der mindestens einen Parallelanordnung des zusätzlichen Strangs in den verbundenen Zustand;
Messen eines durch den zusätzlichen Strang fließenden Stroms unter Verwendung des Amperemeters des zusätzlichen Strangs während einer zusätzlichen Zeitspanne nach dem Ändern der mindestens einen Parallelanordnung des zusätzlichen Strangs in den verbundenen Zustand;
Bestimmen, ob eine Änderung des Stroms während der zusätzlichen Zeitspanne größer als eine Schwellenwertstromänderung ist;
in einem Fall, in dem die Änderung des Stroms während der zusätzlichen Zeitspanne die Schwellenwertstromänderung nicht überschreitet, Bereitstellen einer Benachrichtigung, dass die Strangsicherung des zusätzlichen Strangs in einem durchgebrannten Zustand ist; und
wobei in einem Fall, in dem die Änderung des Stroms während der zusätzlichen Zeitspanne größer als die Schwellenwertstromänderung ist, die Strangsicherung des zusätzlichen Strangs als intakt bestimmt wird.

6. Verfahren nach Anspruch 5, wobei jeder Strang mehr als eine Parallelanordnung umfasst.

7. Verfahren nach Anspruch 4, wobei das Bestimmen des Zustands der ersten Strangsicherung und das Bestimmen des Zustands der zweiten Strangsicherung sequenziell erfolgen.

8. Verfahren nach Anspruch 5, wobei das Bestimmen des Zustands der ersten Strangsicherung, der zweiten Strangsicherung und der Strangsicherung jedes zusätzlichen Strangs sequenziell erfolgt.

9. Verfahren nach Anspruch 1, wobei die Bestimmung des Zustands der ersten Strangsicherung (111) durchgeführt wird, wenn das Batteriepack im Standby-Modus ist.

10. Verfahren nach Anspruch 8, wobei die Bestimmung des Zustands der ersten Strangsicherung, der zweiten Strangsicherung und der dritten Strangsicherung durchgeführt wird, wenn das Batteriepack im Standby-Modus ist.

11. Verfahren nach Anspruch 9, wobei das Batteriepack (100) konfiguriert ist, um ein Elektrofahrzeug mit Strom zu versorgen, und wobei das Verfahren bei einem Schlüssel-EIN-Zustand des Elektrofahrzeugs durchgeführt wird.

12. Verfahren nach Anspruch 1, ferner umfassend Vergleichen eines Stroms jedes verbundenen Strangs des Batteriepackstrangs mit einem Strom des Batteriepacks, wobei in einem Fall, in dem für eine Zeitspanne länger als eine Schwellenwertzeit der Strom des Batteriepacks über einem Packschwellenwert liegt und der Strom des verbundenen Strangs unter einem Strangschwellenwert liegt, das Verfahren ferner das Bereitstellen einer Benachrichtigung umfasst, dass die Strangsicherung des Strangs in einem durchgebrannten Zustand ist.

13. Verfahren nach Anspruch 1, wobei das Batteriepack ferner eine Batteriepacksicherung (753) umfasst, das Verfahren ferner umfassend Bestimmen eines Status der Batteriepacksicherung (753) durch Vergleichen einer Busspannung und einer Batteriepackspannung, wobei in einem Fall, in dem für eine Zeitspanne länger als eine Schwellenwertzeit eine Differenz zwischen der Busspannung und der Batteriepackspannung über einem Spannungsschwellenwert liegt, das Verfahren ferner das Bereitstellen einer Benachrichtigung umfasst, dass die Batteriepacksicherung (753) in einem durchgebrannten Zustand ist.

14. Verfahren nach Anspruch 1, wobei das Batteriepack (700) ferner eine Batteriepacksicherung (753) umfasst und wobei das Batteriepack (700) in einer Multipack-Batterie eingeschlossen ist, die mindestens ein zusätzliches Batteriepack umfasst, das Verfahren ferner umfassend Vergleichen eines Stroms jedes verbundenen Batteriepacks der Multipack-Batterie mit einem Strom der Multipack-Batterie, wobei in einem Fall, in dem der Strom der Multipack-Batterie über einem Batteriestromschwellenwert liegt und der Strom des Batteriepacks unter einem Packstromschwellenwert liegt, das Verfahren ferner das Benachrichtigen eines Bedieners umfasst, dass die Batteriepacksicherung (753) in einem durchgebrannten Zustand ist.

15. Verfahren nach Anspruch 12, wobei der Schritt des Vergleichens eines Stroms jedes Strangs mit einem Strom des Batteriepacks (700) kontinuierlich durchgeführt wird, während das Batteriepack (700) angeschlossen ist.

16. Verfahren nach Anspruch 1, wobei in einem Fall, in dem eine Strangsicherung in einem durchgebrannten Zustand ist, das Verfahren ferner das Anpassen einer Strombegrenzung des Batteriepacks umfasst.

17. Verfahren nach Anspruch 13, wobei in einem Fall, in dem die Batteriepacksicherung (753) in einem durchgebrannten Zustand ist, das Verfahren ferner das Anpassen einer Strombegrenzung der Multipack-Batterie umfasst.

18. Batteriemanagementsystem (1060), das konfiguriert ist, um das Verfahren nach Anspruch 1 durchzuführen, wobei das Batteriemanagementsystem eine Steuerung umfasst, die kommunikativ mit der mindestens einen Parallelanordnung und dem ersten Amperemeter gekoppelt ist.

19. Maschine, umfassend:
eine elektrische Last (1010);
ein Batteriepack (1020), das mit der elektrischen Last (1010) gekoppelt ist, das Batteriepack (1020) umfassend:
einen ersten Strang, umfassend:
eine erste Strangsicherung;
mindestens eine Parallelanordnung, die eine Batteriezelle und einen Widerstand umfasst, wobei die Parallelanordnung konfiguriert ist, um änderbar zu sein zwischen:
einem verbundenen Zustand, wobei der Widerstand parallel zu der Batteriezelle verbunden ist; und
einem getrennten Zustand, wobei der Widerstand von der Batteriezelle getrennt ist; und
ein erstes Amperemeter, wobei die erste Strangsicherung, die mindestens eine Parallelanordnung und das erste Amperemeter in Reihe verbunden sind; und
einen zweiten Strang, der parallel zu dem ersten Strang verbunden ist, wobei der zweite Strang mindestens eine Batteriezelle umfasst; und
ein Batteriemanagementsystem (1060), das konfiguriert ist, um das Verfahren nach Anspruch 1 durchzuführen.

20. Verfahren zum Erkennen der Anwesenheit oder der Abwesenheit eines offenen Schaltkreises in einem Batteriepack, wobei das Batteriepack Folgendes umfasst:
einen ersten Strang, umfassend:
mindestens eine Parallelanordnung, die eine Batteriezelle und einen Widerstand umfasst, wobei die Parallelanordnung konfiguriert ist, um änderbar zu sein zwischen:
einem verbundenen Zustand, wobei der Widerstand parallel zu der Batteriezelle verbunden ist; und
einem getrennten Zustand, wobei der Widerstand von der Batteriezelle getrennt ist; und
ein erstes Amperemeter, wobei die mindestens eine Parallelanordnung und das erste Amperemeter in Reihe verbunden sind; und
einen zweiten Strang, der parallel zu dem ersten Strang verbunden ist, wobei der zweite Strang mindestens eine Batteriezelle umfasst;
das Verfahren umfassend:
Ändern der mindestens einen Parallelanordnung in den verbundenen Zustand (1110);
Messen eines durch den ersten Strang fließenden ersten Stroms unter Verwendung des ersten Amperemeters während einer ersten Zeitspanne, nachdem die mindestens eine Parallelanordnung in den verbundenen Zustand geändert ist (1120);
Bestimmen, ob eine Änderung des ersten Stroms während der ersten Zeitspanne größer als eine Schwellenwertstromänderung ist (1130); und
in einem Fall, in dem die Änderung des ersten Stroms während der ersten Zeitspanne die Schwellenwertstromänderung nicht überschreitet, Bereitstellen einer Benachrichtigung, dass der erste Strang eine Unterbrechung in dem Schaltkreis umfasst (1150);
wobei in einem Fall, in dem die Änderung des ersten Stroms während der ersten Zeitspanne größer als die Schwellenwertstromänderung ist, der erste Strang als intakt bestimmt wird (1160).

## Revendications

1. Procédé de détermination d'un état d'un fusible dans un bloc de batterie (100), dans lequel le bloc de batterie (100) comprend :
une première branche (110) comprenant :
un fusible de première branche (111) ;
au moins un agencement parallèle (120) comprenant une cellule de batterie (121) et une résistance (122), dans lequel l'agencement parallèle (120) est configuré pour être variable entre :
un état connecté, dans lequel la résistance (122) est connectée en parallèle à la cellule de batterie (121) ; et
un état déconnecté, dans lequel la résistance (122) est déconnectée de la cellule de batterie (121) ; et
un premier ampèremètre (112), dans lequel le fusible de première branche (111), l'au moins un agencement parallèle (120) et le premier ampèremètre (112) sont connectés en série ; et
une deuxième branche (130) connectée en parallèle à la première branche (110), la deuxième branche (130) comprenant au moins une cellule de batterie (131) ;
le procédé comprenant la détermination d'un état du fusible de première branche (111) par :
le passage de l'au moins un agencement parallèle (120) de la première branche (110) à l'état connecté ;
la mesure d'un premier courant passant à travers la première branche (110) à l'aide du premier ampèremètre (112) pendant une première période de temps après que l'au moins un agencement parallèle (120) est passé à l'état connecté ;
le fait de déterminer si une variation du premier courant pendant la première période de temps est supérieure à une variation de courant seuil ; et
au cas où la variation du premier courant pendant la première période de temps ne dépasse pas la variation de courant seuil, la fourniture d'une notification indiquant que le fusible de première branche (111) est dans un état grillé ;
dans lequel, au cas où la variation du premier courant pendant la première période de temps est supérieure à la variation de courant seuil, le fusible de première branche (111) est déterminé comme étant intact.

2. Procédé selon la revendication 1, dans lequel la première branche (110) comprend au moins deux agencements parallèles connectés en série, dans lequel chaque agencement parallèle comprend une cellule de batterie et une résistance et dans lequel chaque agencement parallèle est configuré pour être modificable entre un état connecté dans lequel la résistance est connectée en parallèle à la cellule de batterie et un état déconnecté dans lequel la résistance est déconnectée de la cellule de batterie.

3. Procédé selon la revendication 2, dans lequel le procédé comprend le passage des au moins deux agencements parallèles à l'état connecté.

4. Procédé selon la revendication 1, dans lequel la deuxième branche (630) comprend :
un fusible de deuxième branche (631) ;
au moins un agencement parallèle (640) comprenant une cellule de batterie (641) et une résistance (642), dans lequel l'agencement parallèle (640) est configuré pour être modifiable entre :
un état connecté, dans lequel la résistance (642) est connectée en parallèle à la cellule de batterie (641) ; et
un état déconnecté, dans lequel la résistance (642) est déconnectée de la cellule de batterie (641) ; et
un second ampèremètre (632), dans lequel le fusible de deuxième branche (631), l'au moins un agencement parallèle (640) de la deuxième branche (630) et le second ampèremètre (632) sont connectés en série ;
le procédé comprenant en outre la détermination d'un état du fusible de deuxième branche (631) par :
le passage de l'au moins un agencement parallèle (640) de la deuxième branche (630) à l'état connecté ;
la mesure d'un second courant passant à travers la première branche (610) à l'aide du second ampèremètre (632) pendant une seconde période de temps après que l'au moins un agencement parallèle (640) de la deuxième branche (630) est passé à l'état connecté ;
le fait de déterminer si une variation du second courant pendant la seconde période de temps est supérieure à une variation de courant seuil ;
au cas où la variation du second courant pendant la seconde période de temps ne dépasse pas la variation de courant seuil, la fourniture d'une notification indiquant que le fusible de deuxième branche (631) est dans un état grillé ; et
dans lequel, au cas où la variation du second courant pendant la seconde période de temps est supérieure à la variation de courant seuil, le fusible de deuxième branche (631) est déterminé comme étant intact.

5. Procédé selon la revendication 4, dans lequel :
le bloc de batterie comprend en outre au moins une branche supplémentaire connectée en parallèle à la première branche et à la deuxième branche, chaque branche supplémentaire comprenant :
un fusible de branche ;
au moins un agencement parallèle comprenant une cellule de batterie et une résistance, dans lequel l'agencement parallèle est configuré pour être variable entre :
un état connecté, dans lequel la résistance est connectée en parallèle à la cellule de batterie ; et
un état déconnecté, dans lequel la résistance est déconnectée de la cellule de batterie ; et
un ampèremètre, dans lequel le fusible de branche, l'au moins un agencement parallèle et l'ampèremètre de chaque branche supplémentaire sont connectés en série ; et
pour chaque branche supplémentaire, le procédé comprend en outre la détermination d'un état du fusible de branche de la branche supplémentaire par :
le passage de l'au moins un agencement parallèle de la branche supplémentaire à l'état connecté ;
la mesure d'un courant passant à travers la branche supplémentaire à l'aide de l'ampèremètre de la branche supplémentaire pendant une période de temps supplémentaire après le passage de l'au moins un agencement parallèle de la branche supplémentaire à l'état connecté ;
le fait de déterminer si une variation du courant pendant le laps de temps supplémentaire est supérieure à une variation de courant seuil ;
au cas où la variation du courant pendant le laps de temps supplémentaire ne dépasse pas la variation de courant seuil, la fourniture d'une notification indiquant que le fusible de branche de la branche supplémentaire est dans un état grillé ; et
dans lequel, au cas où la variation du courant pendant le laps de temps supplémentaire est supérieure à la variation de courant seuil, le fusible de branche de la branche supplémentaire est déterminé comme étant intact.

6. Procédé selon la revendication 5, dans lequel chaque branche comprend plus d'un agencement parallèle.

7. Procédé selon la revendication 4, dans lequel la détermination de l'état du fusible de première branche et la détermination de l'état du fusible de deuxième branche se produisent séquentiellement.

8. Procédé selon la revendication 5, dans lequel la détermination de l'état du fusible de première branche, du fusible de deuxième branche et du fusible de branche de chaque branche supplémentaire se produit séquentiellement.

9. Procédé selon la revendication 1, dans lequel la détermination de l'état du fusible de première branche (111) est réalisée lorsque le bloc de batterie est en mode veille.

10. Procédé selon la revendication 8, dans lequel la détermination de l'état du fusible de première branche, du fusible de deuxième branche et du fusible de troisième branche est réalisée lorsque le bloc de batterie est en mode veille.

11. Procédé selon la revendication 9, dans lequel le bloc de batterie (100) est configuré pour alimenter un véhicule électrique et dans lequel le procédé est réalisé à un état de contact mis du véhicule électrique.

12. Procédé selon la revendication 1, comprenant en outre la comparaison d'un courant de chaque branche connectée de la branche de bloc de batterie à un courant du bloc de batterie, dans lequel, au cas où pendant une période de temps supérieure à un temps seuil, le courant du bloc de batterie est supérieur à un seuil de bloc, et le courant de la branche connectée est inférieur à un seuil de branche, le procédé comprend en outre la fourniture d'une notification indiquant que le fusible de branche de la branche est dans un état grillé.

13. Procédé selon la revendication 1, dans lequel le bloc de batterie comprend en outre un fusible de bloc de batterie (753), le procédé comprenant en outre la détermination d'un état du fusible de bloc de batterie (753) en comparant une tension de bus et une tension de bloc de batterie, dans lequel, au cas où une différence entre la tension de bus et la tension de bloc de batterie est supérieure à un seuil de tension pendant une période de temps supérieure à un temps seuil, le procédé comprend en outre la fourniture d'une notification indiquant que le fusible de bloc de batterie (753) est dans un état grillé.

14. Procédé selon la revendication 1, dans lequel le bloc de batterie (700) comprend en outre un fusible de bloc de batterie (753) et dans lequel le bloc de batterie (700) est incluse dans une batterie multiblocs comprenant au moins un bloc de batterie supplémentaire, le procédé comprenant en outre la comparaison d'un courant de chaque bloc de batterie connecté de la batterie multiblocs à un courant de la batterie multiblocs, dans lequel, au cas où le courant de la batterie multiblocs est supérieur à un seuil de courant de batterie et le courant du bloc de batterie est inférieur à un seuil de courant de bloc, le procédé comprend en outre la notification à un opérateur que le fusible de bloc de batterie (753) est dans un état grillé.

15. Procédé selon la revendication 12, dans lequel l'étape de comparaison d'un courant de chaque branche à un courant du bloc de batterie (700) est réalisée en continu pendant que le bloc de batterie (700) est en ligne.

16. Procédé selon la revendication 1, dans lequel au cas où un fusible de branche est dans un état grillé, le procédé comprend en outre le réglage d'une limite de courant du bloc de batterie.

17. Procédé selon la revendication 13, dans lequel, au cas où le fusible de bloc de batterie (753) est dans un état grillé, le procédé comprend en outre le réglage d'une limite de courant de la batterie multiblocs.

18. Système de gestion de batterie (1060) configuré pour réaliser le procédé selon la revendication 1, dans lequel le système de gestion de batterie comprend un dispositif de commande couplé de manière communicante à l'au moins un agencement parallèle et au premier ampèremètre.

19. Machine comprenant :
une charge électrique (1010) ;
un bloc de batterie (1020) couplé à la charge électrique (1010), le bloc de batterie (1020) comprenant :
une première branche comprenant :
un fusible de première branche ;
au moins un agencement parallèle comprenant une cellule de batterie et une résistance, dans lequel l'agencement parallèle est configuré pour être modifiable entre :
un état connecté, dans lequel la résistance est connectée en parallèle à la cellule de batterie ; et
un état déconnecté, dans lequel la résistance est déconnectée de la cellule de batterie ; et
un premier ampèremètre, dans lequel le fusible de première branche, l'au moins un agencement parallèle et le premier ampèremètre sont connectés en série ; et
une deuxième branche connectée en parallèle à la première branche, la deuxième branche comprenant au moins une cellule de batterie ; et
un système de gestion de batterie (1060) configuré pour réaliser le procédé selon la revendication 1.

20. Procédé de détection de la présence ou de l'absence d'un circuit ouvert dans un bloc de batterie, dans lequel le bloc de batterie comprend :
une première branche comprenant :
au moins un agencement parallèle comprenant une cellule de batterie et une résistance, dans lequel l'agencement parallèle est configuré pour être modifiable entre :
un état connecté, dans lequel la résistance est connectée en parallèle à la cellule de batterie ; et
un état déconnecté, dans lequel la résistance est déconnectée de la cellule de batterie ; et
un premier ampèremètre, dans lequel l'au moins un agencement parallèle et le premier ampèremètre sont connectés en série ; et
une deuxième branche connectée en parallèle à la première branche, la deuxième branche comprenant au moins une cellule de batterie ;
le procédé comprenant :
le passage de l'au moins un agencement parallèle à l'état connecté (1110) ;
la mesure d'un premier courant passant à travers la première branche à l'aide du premier ampèremètre pendant une première période de temps après que l'au moins un agencement parallèle est passé à l'état connecté (1120) ;
le fait de déterminer si une variation du premier courant pendant la première période de temps est supérieure à une variation de courant seuil (1130) ; et
au cas où la variation du premier courant pendant la première période de temps ne dépasse pas la variation de courant seuil, la fourniture d'une notification indiquant que la première branche comprend une coupure dans le circuit (1150) ;
dans lequel, au cas où la variation du premier courant pendant la première période de temps est supérieure à la variation de courant seuil, la première branche est déterminée comme étant intacte (1160).
